Europäisches Patentamt

European Patent Office

Office européen des brevets

(11) Publication number: **0 318 306**
**A2**

# EUROPEAN PATENT APPLICATION

(21) Application number: **88311171.8**

(22) Date of filing: **25.11.88**

(51) Int. Cl.⁴: **H 03 B 5/18**

(30) Priority: **27.11.87 JP 299383/87**
**27.11.87 JP 299384/87**

(43) Date of publication of application:
**31.05.89 Bulletin 89/22**

(84) Designated Contracting States: **DE FR GB**

(71) Applicant: **SONY CORPORATION**
**7-35 Kitashinagawa 6-Chome Shinagawa-ku**
**Tokyo 141 (JP)**

(72) Inventor: **Murakami, Yoshikazu Patents Division**
**c/o Sony Corporation 6-7-35 Kitashinagawa**
**Shinagawa-ku Tokyo 141 (JP)**

**Mizunuma, Yasuyuki Patents Division**
**c/o Sony Corporation 6-7-35 Kitashinagawa**
**Shinagawa-ku Tokyo 141 (JP)**

**Ohgihara, Takahiro Patents Division**
**c/o Sony Corporation 6-7-35 Kitashinagawa**
**Shinagawa-ku Tokyo 141 (JP)**

**Nakano, Hiroyuki Patents Division**
**c/o Sony Corporation 6-7-35 Kitashinagawa**
**Shinagawa-ku Tokyo 141 (JP)**

**Niikura, Kanako Patents Division**
**c/o Sony Corporation 6-7-35 Kitashinagawa**
**Shinagawa-ku Tokyo 141 (JP)**

**Okamoto, Tsutomu Patents Division**
**c/o Sony Corporation 6-7-35 Kitashinagawa**
**Shinagawa-ku Tokyo 141 (JP)**

(74) Representative: **Pilch, Adam John Michael et al**
**c/o D. Young & Co. 10 Staple Inn**
**London WC1V 7RD (GB)**

(54) **Tuned oscillators.**

(57) A tuned oscillator comprises an active element such as an FET (1) for oscillation and an YIG thin film ferrimagnetic resonator (2) connected to the FET (1) as part of a feedback circuit for the FET (1). The YIG thin film resonator (2) includes an YIG disc (2a) and has a bias magnetic field (H) applied perpendicular to a surface of the YIG disc (2a) to set the resonant frequency. The magnetic field (H) is generated both by a permanent magnet (4c) for providing a fixed component of the field and also by a coil (4b) for providing a variable component of the field. The resonant frequency is stabilised by a PLL circuit (5) connected to an output of the oscillator and with a feedback connection to the coil (4b). Since the YIG thin film tuned oscillator has a high Q value, high quality communication signal processing can be achieved. The YIG tuned oscillator may be used as a local oscillator for a transceiver.

FIG. I

EP 0 318 306 A2

## Description

## TUNED OSCILLATORS

This invention relates to tuned oscillators utilising a thin film ferrimagnetic resonator, which can be used in microwave communication apparatus.

Known local oscillators used in the radio frequency (RF) stage of microwave communication equipment include oscillators using a dielectric resonator (DRO) and a voltage controlled oscillator (VCO). The DRO, owing to a high Q value, operates with low phase noise, allowing data communication equipment to operate at a low bit error rate (BER) and, for example, video signal communication equipment to operate at a high signal to noise (SN) ratio.

On the other hand, because it is a fixed oscillator, the basis of operation of the DRO depends on block conversion, in which signals in the communication band are converted in batches to the intermediate frequency (IF), and a necessary signal is selected with the VCO in the IF stage. It therefore imposes the problem of requiring an intricate IF stage, such as one including a tracking filter for blocking the image signal. In the case of using a VCO as a local oscillator, signals can be selected in the RF stage, which simplifies the IF stage, but due to a low Q value of the varactor diode typically used as an oscillation active element, the phase noise characteristics are inferior, resulting unfavourably in a deteriorated BER characteristic for data communication and a deteriorated SN ratio for video signal communication.

Recently, a tuning oscillator has been proposed which utilises the ferrimagnetic resonance of an yttrium iron garnet (YIG) sphere, which is a ferrimagnetic material (see Japanese Patent Publication No. 53-32671). This YIG-tuned oscillator (YTO), having a high Q value of the YIG resonator, operates with low phase noise and its use of magnetic resonance provides satisfactory linear tuning characteristics which are the advantages of both the DRO and the VCO.

Other publications of interest include US Patent No.US-A-4 626 800 which discloses a tuned oscillator using an YIG thin fim magnetic resonator, and US Patent Nos. US-A-4 745 380 and 4 746 884 which disclose a technique for compensating the temperature dependency of the ferrimagnetic resonance frequency of the thin film YIG resonator by replacing a proportion of the ferric ions ($Fe^{3+}$) in the YIG thin film by non-magnetic ions.

However, the previously-proposed YTO using the above-mentioned YIG sphere has been difficult to use as a local oscillator in communication equipment for the following reasons. Primarily, the d.c. magnetic field applied to the YIG sphere, on which the intended oscillation frequency is dependent, is generated entirely by feeding a current to a coil, which not only imposes a large current consumption in the coil, but also a large inductance of the coil due to its large number of turns, resulting in a retarded tuning response and in large dimensions of the oscillator. Secondly, the difficulty in manufacturing the YIG sphere makes mass production of a YTO with a YIG sphere unfavourable and also expensive, and accordingly it is disadvantageous for communication equipment in which mass-production and low cost are required.

According to one aspect of the invention there is provided a tuned oscillator utilising a thin film ferrimagnetic resonator, the oscillator comprising:
an active element for oscillation;
a thin film ferrimagnetic resonance element formed of a thin film ferrimagnetic plate and a transmission line coupled to said thin film ferrimagnetic plate, the element being connected to said active element as part of a feedback circuit for said active element;
bias magnetic field means for applying a bias magnetic field perpendicular to said thin film ferrimagnetic plate; and
a phase lock loop circuit operable to receive an oscillation output and to generate a control signal to stabilise the oscillation;
said bias magnetic field means comprising a permanent magnet generating a fixed bias magnetic field component and a coil for generating a variable bias magnetic field component, said coil, in use, receiving a current controlled by said control signal obtained from said phase lock look circuit.

A preferred embodiment of this invention, to be described in greater detail hereinafter, provides a tuned oscillator which is rapid in frequency tuning reponse, which is low in power consumption, and which is compact. The preferred tuned oscillator is suitable for mass product and yet inexpensive, includes a simple circuit arrangement for channel selection, and enables high quality communications.

Communication equipment including the preferred tuned oscillator can have a simple intermediate frequency stage.

According to another aspect of the invention there is provided a tuned oscillator having an active element for oscillation, a ferrimagnetic thin film resonance element connected to part of a feedback arrangement of the active element, and a d.c. magnetic field application means used to apply a d.c. magnetic field to the ferrimagnetic thin film resonance element, the d.c. magnetic field application means including a permanent magnet for producing a fixed magnetic field component and a coil for producing a variable magnetic field component, with the coil receiving a feedback signal from a phase lock loop circuit.

This arrangement can speed up the tuning response, reduce the size of the tuned oscillator, and simplify the channel selection circuit.

In the preferred embodiment of this invention, an YIG thin film resonator is utilised in which a proportion of the ferric ions of the YIG thin film are replaced by non-magnetic ions to such an extent as to compensate the thermal characteristics of the permanent magnet and the oscillating active element.

Part of the magnetic field necessary for frequency tuning is provided by the permanent magnet, and the coil can therefore have a reduced number of turns in proportion to the fixed magnetic field produced by the permanent magnet. The coil has its inductance reduced accordingly, and consequently the frequency tuning response is enhanced. The reduced number of turns in the coil results in a compact tuned oscillator. The coil current can be reduced as a result of the fixed magnetic field provided by the permanent magnet, and the tuned oscillator can therefore have low power consumption. The ferrimagnetic thin film resonator can readily be manufactured by thin film forming technology and microwave integrated circuit (MIC) technology, making the tuned oscillator suitable for mass production and inexpensive to manufacture. The feedback to the coil based on the phase lock loop simplifies the circuit arrangement for channel selection.

The preferred YIG thin film tuned oscillator can be used in communication equipment as its local oscillator for converting intermediate frequency to communication frequency and vice versa.

Use of the preferred YIG thin film tuned oscillator enables direct signal selection in the RG stage, and the IF stage can be simplified. Because the thin film tuned oscillator uses a thin film YIG resonator of high Q value, it is low in phase noise and contributes to high quality communication. For example, low BER in data communication and high SN ratio in video signal communication are possible.

The invention will now be described by way of example with reference to the accompanying drawings, throughout which like parts are referred to by like references, and in which:

Figure 1 is a block diagram showing a thin film YTO embodying the present invention;

Figure 2 is a graph showing the relationship between the saturation magnetisation of an YIG thin film at room temperature corresponding to a replacement amount of Ga and the variation in resonance frequency;

Figure 3 is a graph showing the thermal characteristics of the YIG thin film resonator with the resonance frequency variation in Figure 2 being virtually zero;

Figure 4 is a graph showing the thermal characteristics of the thin film YTO using the YIG thin film resonator having the thermal characteristics shown in Figure 3;

Figure 5 is a graph showing the thermal characteristics of the YIG thin film resonator with the saturation magnetisation of the YIG thin film being set by adjustment of the replacement amount of Ga;

Figure 6 is a graph showing the thermal characteristics of the thin film YTO using the YIG thin film resonator having the thermal characteristics shown in Figure 5;

Figure 7 is a block diagram showing the arrangement of the up-converter section of a double conversion system for a microwave transmitter using the thin film YTO shown in Figure 1 as a local oscillator;

Figure 8 is a block diagram showing the arrangement of the up-converter section of a single conversion system for a microwave transmitter using the thin film YTO shown in Figure 1 as a local oscillator;

Figure 9 is a diagram showing the basic organisation of a satellite comunication system; and

Figure 10 is a block diagram showing an example of a transceiver RF unit of a double conversion mode for a microwave transceiver using the thin film YTO shown in Figure 1 as a local oscillator.

The preferred embodiment of the present invention will be described in the following order.

(a) YIG thin film tuning oscillator.

(b) Compensation for thermal characteristics of the permanent magnet and the active element.

(c) Microwave communication equipment using the thin film YTO as a local oscillator.

(d) Microwave transceiver for satellite communication.

(a) YIG thin film tuning oscillator (thin film YTO)

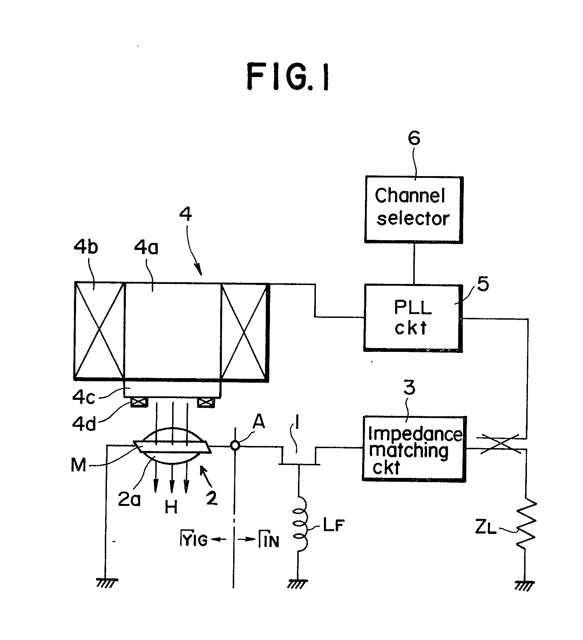

Referring to Figure 1, the thin film YTO of this embodiment includes a GaAs field effect transistor (FET) 1 as an active element for oscillation, an YIG thin film resonator 2 as a feedback element, an impedance matching circuit 3, a d.c. magnetic field application means 4 for applying a d.c. magnetic field to the YIG thin film resonator 2, and a phase locked loop (PLL) circuit 5. A load impedance ZL is connected at the output of the thin film YTO. A channel selection circuit 6 is provided for setting the PLL circuit 5.

The condition of steady-state oscillation of this thin film YTO is expressed in terms of the reflectivity YIG seen from a terminal A to the YIG thin film resonator 2 and the reflectivity $_{IN}$ seen from the terminal A to the GaAs FET 1 acting as the active element, as follows. $\Gamma_{YIG} \cdot \Gamma_{IN} = 1$

The YIG thin film resonator 2 has a structure similar to that described in detail in the aforementioned US Patent No. US-A-4 626 800, and it comprises a ferrimagnetic YIG thin film disc 2a formed on one main surface of a non-magnetic gadolinium gallium garnet (GGG) substrate, for example, by liquid phase epitaxial growth, and a microstrip line. In practice, the YIG thin film resonator 2 is formed together with the GaAs FET 1 on one surface of a dielectric substrate such as alumina. The YIG thin film disc 2a is disposed on a microstrip line M (symbolically shown) formed on the surface of the dielectric substrate, while on another surface of the dielectric substrate there is formed a ground conductor. The YIG thin film resonator 2 can readily be fabricated by thin film forming technology such as liquid phase epitaxy (LPE) and MIC technology, and therefore a tuned oscillator which is suitable for mass production and which is inexpensive can be obtained. Owing to a high Q value of the YIG thin film resonator 2, the thin film YTO of this embodiment is low in phase noise, and use of ferromagnetic resonance provides the thin film YTO with satisfactory linear tuning characteristics. Accordingly, by using the thin film YTO as a local oscillator in communication equipment, high quality communication is made possible.

The GaAs FET 1 has its source connected to the microstrip line M and its drain connected to the impedance matching circuit 3. The gate of the GaAs FET 1 is grounded through a feedback reactance LF. Thus the thin film YTO of this embodiment is a tuned oscillator of the common gate, series feedback type.

The d.c. magnetic field application means 4 is formed by a main coil 4b wound on a pole piece 4a which constitutes part of the yoke of the magnetic circuit, and a permanent magnet 4c made of, for example, $Nd_2Fe_{14}B$, $CeCo_5$, $SmCo_5$, or the like. A fixed magnetic field component produced by the permanent magnet 4c and a variable magnetic field component produced by the main coil 4b combine to form a d.c. magnetic field H applied to the YIG thin film resonator 2 in a direction perpendicular to the surface of the YIG thin film disc 2a. The YIG thin film resonator 2 is positioned in the gap of the magnetic circuit. The d.c. magnetic field H can be controlled to the magnitude required for frequency tuning by varying the current flowing in the main coil 4b. For example, although satellite communication and ground communication using microwaves have different bands depending on each system, the communication bandwidth is about 500 MHz for each system. If the thin film YTO has a lower limit of tuning range of 13 GHz, for example, the full tuning range will be 13 GHz to 13.5 GHz, and therefore the circuit is designed such that the permanent magnet 4c supplies a magnetic field for tuning to 13 GHz and the main coil 4b supplies a variable magnetic field (typically about 180 Oe or 14,300 A/m) only for the remaining 500 MHz. Consequently, the current of the main coil 4b can be reduced significantly compared with the previously-proposed YTO using a YIG sphere, and accordingly the power consumption of the main coil 4b can also be reduced significantly, resulting in a low-power consumption thin film YTO. Owing to a smaller number of turns of the main coil 4b, the thin film YTO can also be more compact. The main coil 4b has its inductance reduced in proportion to the decrease in the number of turns, and the response speed of frequency tuning can thus be improved. For example, data communications generally use a PLL synthesiser system because of the need for a high-stability local oscillator, and the local oscillator must have a frequency tuning response higher than the upper-limit response required for the PLL; the above-mentioned enhancement of the tuning response is therefore advantageous in this respect.

The main coil 4b is connected to the PLL circuit 5, which is connected to the output of the thin film YTO. When channel selection is performed by the channel selection circuit 6 connected to the PLL circuit 5, the oscillation output of the thin film YTO supplied to the PLL circuit 5 is lowered in frequency by a frequency divider, and the divided frequency is compared with the reference frequency provided by a crystal oscillator, a control current which reflects the result of the comparison being produced by the PLL circuit 5 for feeding back to the main coil 4b. In consequence, the current in the main coil 4b, and thus also the magnetic field H applied to the YIG thin film resonator 2, is varied in magnitude so that the intended channel is selected.

As described in this embodiment, direct feedback is provided from the PLL circuit 5 to the main coil 4b, and the circuit arrangement for channel selection can thus be simplified. The direct feedback from the PLL circuit 5 to the main coil 4b is made possible due to the reduction in the number of turns in the main coil 4b, as mentioned above.

As shown in Figure 1, a frequency modulation (FM) coil 4d may be provided in addition to the main coil 4b and the permanent magnet 4c; the FM coil 4d can then be used as a frequency modulator based on the base band signal. A possible control method is to have direct feedback from the PLL circuit 5 to the FM coil 4d, but in this case the circuit arrangement for channel selection becomes complex.

(b) Compensation for thermal characteristics of the permanent magnet and the active element.

Since the permanent magnet 4c and the GaAs FET 1 acting as an active element have inherent thermal characteristics, a change in the temperature causes a variation in the oscillator characteristics. On this account, this embodiment performs compensation for the thermal characteristics of the permanent magnet 4c and the GaAs FET 1, as follows.

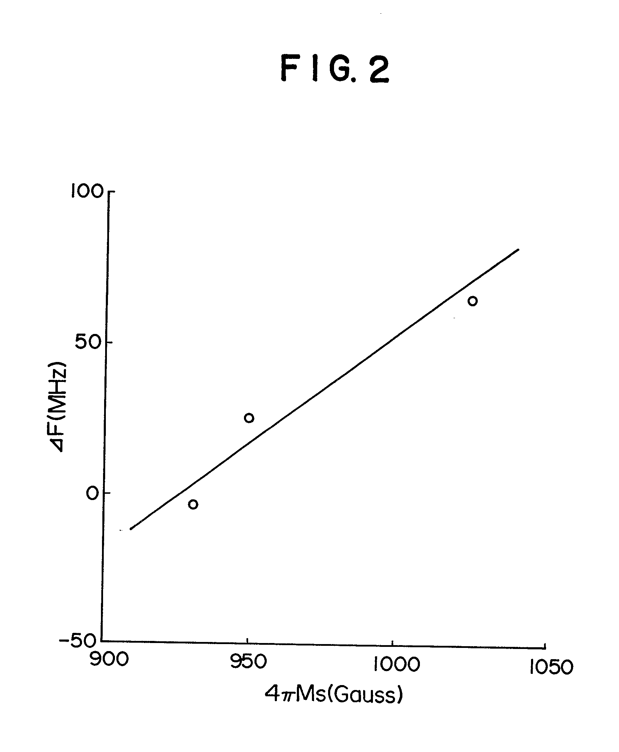

As described in the aforementioned US Patent No. US-A-4 745 380, part of the ferric ion in YIG is replaced by a non-magnetic ion such as gallium (Ga) in accordance with the thermal characteristics of the permanent magnet, and the thermal characteristics of the YIG thin film resonator 2 can be compensated up to the first order temperature coefficient. Figure 2 shows the result of measurement of the thermal characteristics of the YIG thin film resonator, with the replacement amount of Ga being varied. In Figure 2, the abscissa represents the saturation magnetisation 4nMs of the YIG film at room temperature, which corresponds to the replacement amount of Ga, while the ordinate represents the change in resonance frequencies $\Delta F$ between 60 and -30°C. Figure 2 reveals that $\Delta F$ is virtually nullified when 4nMs is about 925 Gauss (0.0925 T).

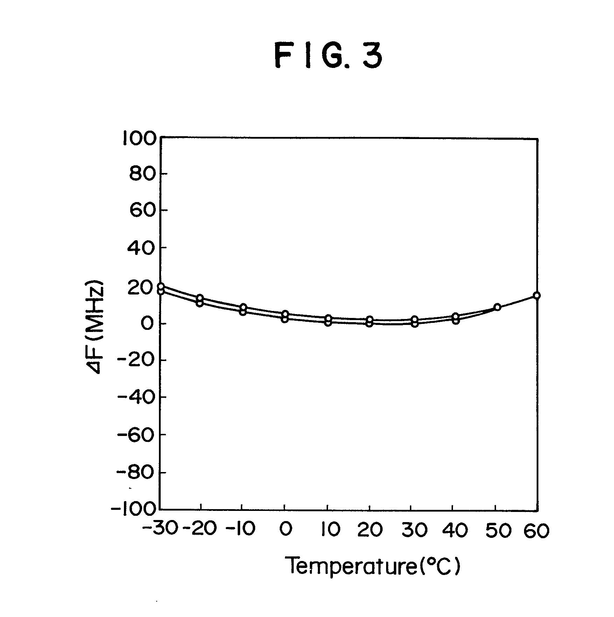

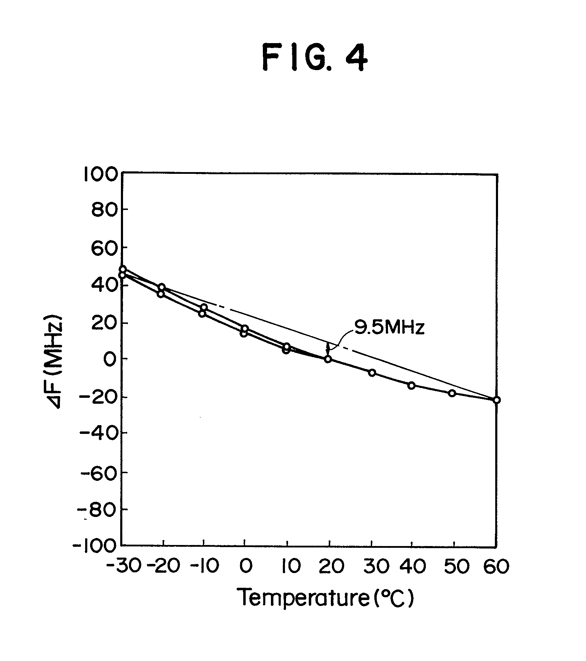

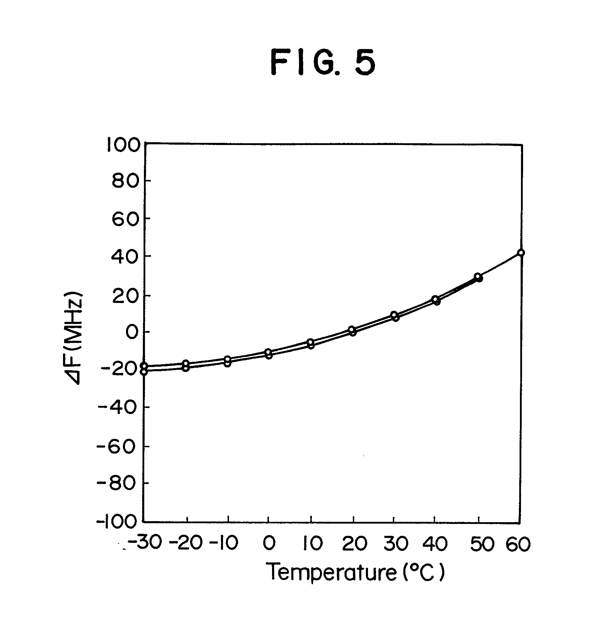

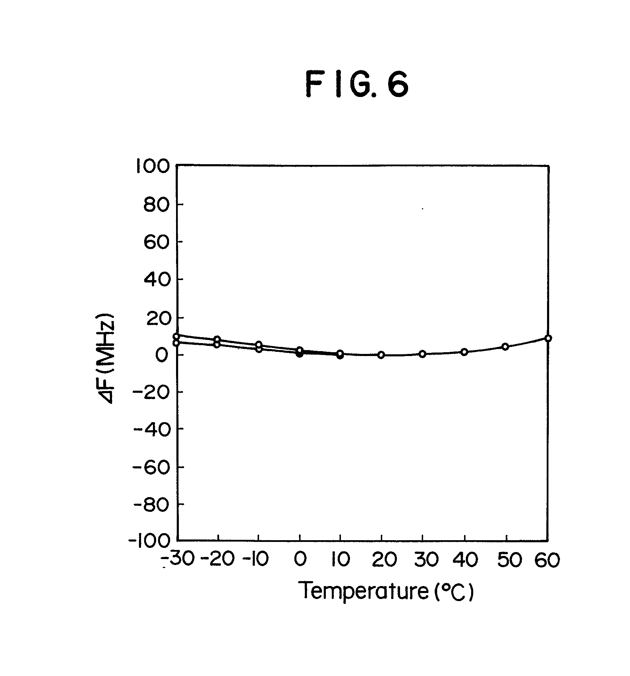

Figure 3 shows the result of measurement of the thermal characteristics of the YIG thin film resonator having $\Delta F$ virtually equal to zero. Figure 3 reveals that the first-order thermal characteristic of the YIG thin film resonator is virtually zero. Among the two closely located curves in Figure 3, the lower curve is the measurement result with descending temperature, and the upper curve is the measurement result with descending temperature (this is also applicable to Figures 4, 5 and 6). Figure 4 shows the result of measurement of the thermal characteristics of the thin film YTO using the YIG thin film resonator. As will be appreciated from Figure 4, even at zero thermal characteristics of the YIG thin film resonator, the variation of oscillation frequency of the thin film YTO between -30 and 60°C is about -65 MHz to reflect the thermal characteristics of the GaAs FET 1. Based on Figure 2, the quantity of replacement of Ga is adjusted so that the saturation magnetisation of the YIG thin film is about 1015 Gauss (0.1015 T) inclusive of the component attributable to the thermal characteristics of the GaAs FET 1. As a result, the YIG thin film resonator has thermal characteristics as shown in Figure 5, and the thermal characteristics of the thin film YTO using the YIG thin film resonator has its first-order coefficient nullified as shown in Figure 6. The variation is oscillation frequency due to temperature in this case can be confined to the 10 MHz curve of the thermal characteristic curve shown in Figure 4. The compensation of the thermal characteristic component of the active element is dependent on the Q value of the YIG thin film resonator, that is the thermal characteristics of the resonator become dominant as the Q value increases, and the thermal characteristics of the active element contribute less to the thermal characteristics of the thin film YTO.

Although in the above explanation the thermal characteristics of the thin film YTO are nullified up to the first-order coefficient by adjustment of the quantity of replacement of Ga, it is possible to nullify the thermal characteristics up to the second-order coefficient by the provision of a soft magnetic plate made of soft ferrite in the gap of the magnetic circuit, in addition to the adjustment of the Ga replacement quantity as generally shown in the aforementioned US Patent No. US-A-4 746 884.

### (c) Microwave communication equipment using the thin film YTO as the local oscillator.

Microwave communication equipment has its RF stage divided into an up-converter section which converts an IF (for example 70 MHz or 140 MHz) signal into a microwave frequency for transmission, and a down-converter section which converts a received microwave frequency into the IF signal. Since these sections have virtually symmetric structure, the following describes the up-converter section only.

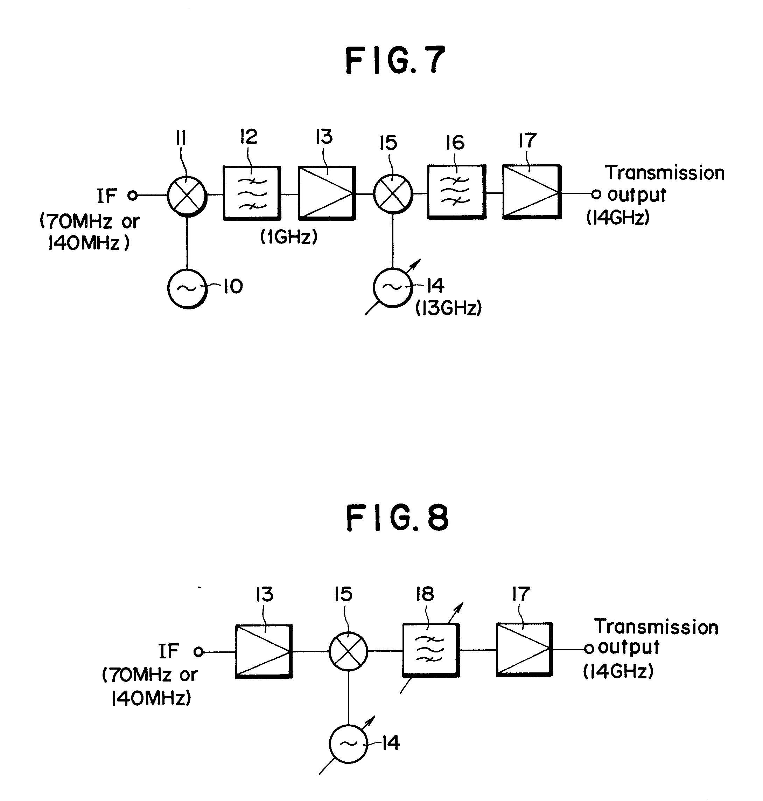

Figure 7 shows the arrangement of the up-converter section of a double conversion mode microwave transmitter. In the microwave transmitter, the IF signal is mixed by a mixer 11 with an RF signal produced by a fixed oscillator 10 to produce a signal of 1 GHz, for example, and thereafter a signal in the required frequency band passes through a band-pass filter 12. Next, the signal is amplified by an IF amplifier 13, and then mixed by a mixer 15 with a signal of 13 GHz, for example, provided by a local oscillator 14 constituted by the previously-described thin film YTO. Consequently, a signal of frequency $13 + 1 = 14$ GHz is formed. Next, the signal is fed through a band-pass filter 16, and then amplified by a high power amplifier (HPA) 17 to produce a transmission output at 14 GHz.

According to the microwave transmitter shown in Figure 7, the 1F signal is first converted to a high frequency of around 1 GHz, for example, and this is advantageous in preventing high level spurious waves from intruding into the communication band. The local oscillator 14 formed by the thin film YTO using the YIG thin film resonator 2 of high Q value enables low BER for data communication and high SN high-quality communication for image communication. Moreover, the capability of signal selection in the RF stage simplifies the structure of the IF stage.

Figure 8 shows the arrangement of the up-converter of a single conversion mode. In the microwave transmitter, the IF signal is amplified by an IF amplifier 13 and thereafter mixed by a mixer 15 with the oscillation output of a local oscillator 14 which is constituted by the thin film YTO, so that the signal is frequency converted to a signal of, for example, 14 GHz. Next, the signal is fed through a YIG thin film tuning filter (thin film YTF) 18 as described in the aforementioned US Patent No. US-A-4 626 800 so that a signal in the required frequency band is extracted, and thereafter the signal is amplified by a high power amplifier 17 to produce a transmission output at 14 GHz.

According to the microwave transmitter shown in Figure 8, high-quality communication can take place, as in the transmitter shown in Figure 7, and at the same time the IF stage can be simplified. The use of the single conversion mode is advantageous in the simplicity of structure compared with the transmitter shown in Figure 7. Furthermore, the YIG thin film tuning filter 18 is a tracking filter having a sharp response curve, and therefore it prevents spurious waves, such as the oscillation output of the thin film YTO and the image signal, from intruding into the communication band at a high level. By separating the thin film YTO and the YIG thin film tuning filter by an offset frequency equal to the intermediate frequency, they can be built in the gap of the same magnetic circuit as shown in US Patent No. US-A-4 704 739. In this case, the control current produced by the PLL is fed back to the common magnetic circuit, and therefore the tracking error can be eliminated in principle.

Although only the up-converter section of the microwave transmitter using the thin film YTO as a local oscillator has been described, the up-converter and down-converter sections can share a local oscillator by choosing the tuning frequency of the thin film YTO to be between the transmission band and the reception band. This example will be described in the following.

### (d) Microwave transceiver for satellite communication

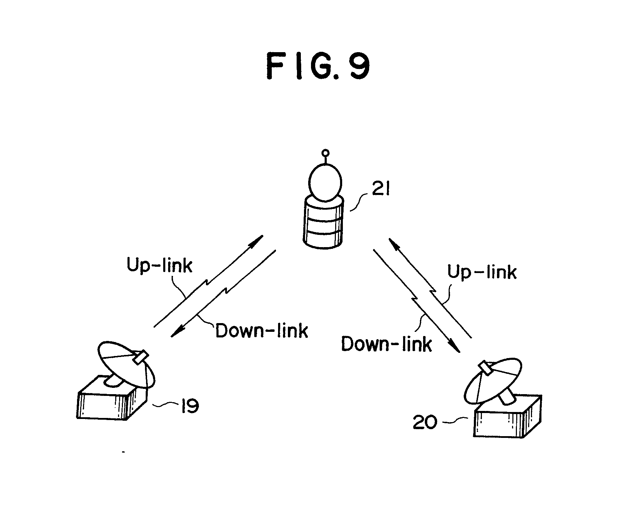

In Figure 9, a satellite communication arrangement involves a microwave link between ground stations 19 and 20 by way of a satellite (space station) 21. The communication lines connecting the ground stations 19 and 20 necessitate a link from the ground station 19 via the satellite 21 to the ground station 20, and another link from the ground station 20 via the satellite 21 to the ground station 19. A communication path from a ground station to a satellite is called an "up-link", while a communication path from the satellite to a ground station is called a "down-link". Generally, different frequencies are used for the up-link and the down-link. For example, in the satellite communication of the "C-band", 6 GHz and 4 GHz are allotted to the up-link and the down-link respectively, and in the satellite communication of the "Ku band", 14 GHz and 12 GHz are allotted to the up-link and the down-link, respectively.

The ground stations 19 and 20 shown in Figure 9 have transceiver RF units each consisting of an up-converter section for converting IF to the up-link microwave frequency and a down-converter section for converting the down-link microwave frequency to IF. By choosing the oscillation frequency of the thin film YTO to be between the up-link frequency band and the down-link frequency band, the up-converter and down-converter can share a local oscillator constituted by the thin film YTO.

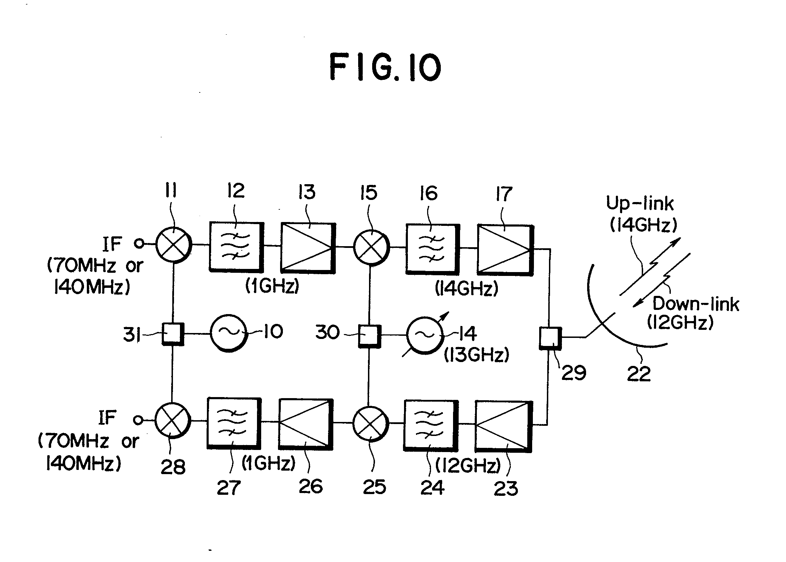

Figure 10 shows an example of the transceiver RF unit of double conversion mode for a microwave transceiver using the thin film YTO as the local oscillator. As shown in Figure 10, IF is converted to 1 GHz by the mixer 11 and further mixed by the mixer 15 with a 13 GHz signal provided by the local oscillator 14 so that it becomes a 14 GHz signal, as mentioned previously, and after being amplified by the high power amplifier 17, it is transmitted as a 14 GHz microwave by means of a parabolic antenna 22. On the reception side, a microwave of 12 GHz, for example, received by the parabolic antenna 22 is amplified by a low noise amplifier (LNA) 23 and, after a signal in the required frequency band has passed through a band-pass filter 24, it is mixed with a 13 GHz signal provided by the local oscillator 14 and thereby converted to a 1 GHz signal. The 1 GHz signal is amplified by an IF amplifier 26 and, after being fed through a band-pass filter 27, it is mixed by a mixer 28 with a signal provided by the fixed oscillator 10 and an IF signal is produced. Switching of transmission and reception is implemented by a duplexer 29 connected to the parabolic antenna 22. Selection as to whether the oscillation output of the local oscillator 14 is to be delivered to the mixer 15 on the transmission side or the mixer 25 on the reception side is implemented by a hybrid circuit 30, and selection as to whether the oscillation output of the fixed oscillator 10 is to be delivered to the mixer 11 on the transmission side or the mixer 28 on the reception side is implemented by a hybrid circuit 31.

Since the local oscillator 14 and the fixed oscillator 10 are shared by the up-converter and the down-converter, the microwave transceiver can be simplified. Features including the capability of high quality communication and the simplicity of the IF stages are similar to the transmitters shown in Figures 7 and 8.

For example, in a microwave transceiver, the up-converter and the down-converter may respectively be arranged in single conversion mode and double conversion mode, with the local oscillator of the thin film YTO being shared by the up-converter and the down-converter, or vice versa. Furthermore, it is possible to configure a transceiver using a thin film YTO as the local oscillator for ground microwave communication, as well as for satellite communication.

As described above, the d.c. magnetic field application means is made up of a permanent magnet for producing a fixed magnetic field component and a coil for producing a variable magnetic field component; the coil can have its number of turns reduced to the extent equivalent to the fixed magnetic field produced by the permanent magnet, when compared to the coil of the previously-proposed arrangement. Accordingly, the inductance of the coil can be reduced by that proportion. Consequently, the response speed of frequency tuning can be enhanced. The tuning oscillator can be made smaller as a result of reduction in the number of turns of the coil. Furthermore, the coil current can be reduced by an amount equivalent to the fixed magnetic field produced by the permanent magnet, whereby a tuning oscillator of low power consumption can be accomplished. Because of the ease of manufacturing the ferrimagnetic thin film resonator, the tuning oscillator is suitable for mass production and is also inexpensive. Because of the feedback to the coil from the PLL, the circuit arrangement for channel selection can be simplified.

Further, the local oscillator for converting IF to the transmission frequency is formed of a YIG thin film tuning oscillator, which enables the signal selection in the RG stage, and consequently the IF stage, to be simplified. The YIG thin film tuning oscillator uses a YIG thin film resonator with a high Q value, and therefore the phase noise is low and accordingly high quality communication is possible.

## Claims

1. A tuned oscillator utilising a thin film ferrimagnetic resonator, the oscillator comprising:

an active element (1) for oscillation;

a thin film ferrimagnetic resonance element (2) formed of a thin film ferrimagnetic plate (2a) and a transmission line (M) coupled to said thin film ferrimagnetic plate (2a), the element (2) being connected to said active element (1) as part of a feedback circuit for said active element (1);

bias magnetic field means (4) for applying a bias magnetic field (H) perpendicular to said thin film ferrimagnetic plate (2a); and

a phase lock loop circuit (5) operable to receive an oscillation output and to generate a control signal to stabilise the oscillation;

said bias magnetic field means (4) comprising a permanent magnet (4c) generating a fixed bias magnetic field component and a coil (4b) for generating a variable bias magnetic field component, said coil (4b), in use, receiving a current controlled by said control signal obtained from said phase lock loop circuit (5).

2. A tuned oscillator according to claim 1, wherein the tuned oscillator is capable of oscillating between a lowest frequency and a highest frequency, said permanent magnet (4c) is arranged to generate said fixed bias magnetic field component to cause resonance in said ferrimagnetic plate (2a) at said lowest frequency, and said coil (4b) is operable to generate said variable bias magnetic field component to cause resonance in said ferrimagnetic plate (2a) at frequencies between said lowest and highest frequencies.

3. A tuned oscillator according to claim 1 or claim 2, wherein said thin film ferrimagnetic plate (2a) is formed of yttrium iron garnet.

4. A tuned oscillator according to claim 3, wherein a proportion of the ferric ions in the ferrimagnetic plate (2a) are substituted by non-magnetic ions to reduce the saturation magnetisation of the yttrium iron garnet to compensate for the temperature characteristics of said permanent magnet (4c), said thin film resonance element (2a) and said active element (1).

5. A signal transmitter utilising a tuned oscillator according to any one of claims 1 to 4 as a local oscillator (14) for converting an intermediate frequency signal to a transmission frequency signal.

6. A signal receiver utilising a tuned oscillator according to any one of claims 1 to 4 as a local oscillator (14) for converting a received signal to an intermediate frequency signal.

7. A signal transceiver utilising a tuned oscillator according to any one of claims 1 to 4 as a single local oscillator (14) both for converting an intermediate frequency signal to a transmission frequency signal, and for converting a received signal to an intermediate frequency signal.

# FIG. 1

# F I G. 2

# F I G. 3

# FIG. 4

# F I G. 5

# FIG. 6

# FIG. 7

IF
(70MHz or
140MHz)

11   12   13   15   16   17

10

14
(13GHz)

(1GHz)

Transmission
output
(14GHz)

# FIG. 8

13   15   18   17

IF
(70MHz or
140MHz)

14

Transmission
output
(14GHz)

# FIG.9

# FIG. 10